# EUROPEAN PATENT APPLICATION

(11) **EP 4 368 596 A1**
(43) Date of publication of application: **15.05.2024**
(21) Application number: 22861744.5
(22) Date of filing: 25.08.2022
(51) Int. Cl.: C04B 35/447

(54) **ROOM TEMPERATURE AND NORMAL PRESSURE SUPERCONDUCTING CERAMIC COMPOUND, AND METHOD FOR MANUFACTURING SAME**

(30) Priority: 25.08.2021 KR 20210112104
(71) Applicant: Quantum Energy Research Centre (Q-Centre), Seoul 05822 (KR)
(72) Inventor: LEE, Sukbae, Seoul 05822 (KR); KIM, Ji Hoon, Seoul 01487 (KR); KWON, Young-Wan, Seoul 02831 (KR)
(74) Representative: RGTH
(86) International application number: PCT/KR2022/012773
(87) International publication number: WO 2023/027536

(57) **Abstract**

Disclosed are a superconducting ceramic and methods for producing the same. The superconducting ceramic is represented by Formula 1, which is described in the specification. The methods are suitable for producing the superconducting ceramic. The superconducting ceramic exhibits superconductivity at room temperature and ambient pressure.

## Description

### Technical Field

The present invention relates to a room-temperature and ambient-pressure superconducting ceramic and methods for producing the same. More specifically, the present invention relates to a superconducting ceramic that exhibits superconductivity at room temperature and ambient pressure and methods for producing the superconducting ceramic.

### Background Art

Tremendous technological advances have been made in dealing with electrons, to the point where the modern world is called the age of electricity and electronics. The underlying aspect for modern technological advances, of course, lies in sufficient supply of power based on electricity generation, transmission, and distribution. The sufficient supply of power has brought about the development of primary and secondary batteries as power storage media and even wireless power transmission and reception technology and is thus considered a driving force to achieve huge modern developments.

The use of low resistance materials such as copper and gold offers an alternative to solve recently emerging environmental and energy issues and a fundamental solution to the problems (for example, low efficiency) encountered in the high integration/densification of semiconductors. Thus, there is a need to find new materials that can replace low resistance materials while avoiding the problems of the prior art.

Recently, high-temperature superconductors have attracted attention as replacements for low resistance materials. The publication of a new class of superconducting materials with a critical temperature (Tc) above the upper limit of the critical temperature predicted by Bednorz and Muller and the classical BCS theory in 1986 (Bednorz, et al, ZPhys B 64, 189 (1986)) surprised the solid-state physics community. These materials are ceramics consisting of copper oxide layers separated by buffer cations. In the Bednorz and Muller's original material (LBCO), the buffer cations are lanthanum and barium ions. Their work has inspired Paul Chu to synthesize a similar material containing yttrium and barium ions as buffer ions. This material is YBCO, the first superconductor with a Tc exceeding the boiling point of liquid nitrogen (77 K) (Wu, et al, Phys Rev Lett 58, 908 (1987)).

According to a report that marked a similar milestone, hydrogen sulfide shows the highest critical temperature of 203.5 K at a pressure of 155 GPa (Conventional superconductivity at 203 kelvin at high pressures in the sulfur hydride system. Nature 525, 73 (2015)).

Even afterwards, related studies have been conducted using similar materials. The critical temperature of recent superconducting materials has been reported to be continuously increasing. For example, a superconducting material reported in 2020 has a critical temperature of 15 °C close to room temperature but requires a very high pressure of 267 GPa. As a result of repeated efforts to lower the required pressure, a material exhibiting superconductivity at about -5 °C and an applied pressure of 186 GPa was reported in 2021. However, the temperature and pressure conditions seem to make it difficult to apply the material to daily life (https://en.Wikipedia.org/wiki/Room-temperature_superconductor).

Despite the fact that the experimental results for the hydrogen sulfide and yttrium superhydride superconducting materials create high expectations for room-temperature superconductors in the academic community, the very high pressures 267 GPa and 186 GPa correspond to approximately 200,000 times higher than the atmospheric pressure (1 atm), making the superconducting materials substantially impossible to apply to industrial fields. Particularly, 267 GPa is converted into more than 2,700 tons applied to an area of 1 cm².

Thus, there is a need to develop superconducting materials that can be used not only at room temperature but also ambient pressure. Superconducting materials other than hydrogen sulfide or yttrium superhydride-based materials that do not require high pressure are considered highly applicable across all industries.

A material containing a small amount of a room-temperature and ambient-pressure superconductor with a critical temperature of 313 K is disclosed in a patent application filed by the present applicant. The presence of the superconductor was identified by analyzing the magnetic properties of the material and MAMMA but the amount of the superconductor in the material is not sufficient to identify electrical properties unique to superconductors.

### Detailed Description of the Invention

### Problems to be Solved by the Invention

A first object of the present invention is to provide a superconducting ceramic that exhibits superconductivity at room temperature and ambient pressure.

A second object of the present invention is to provide a method for producing a superconducting ceramic that exhibits superconductivity at room temperature and ambient pressure.

A third object of the present invention is to provide a solid-phase method for producing a superconducting ceramic that exhibits superconductivity at room temperature and ambient pressure.

### Means for Solving the Problems

A first aspect of the present invention provides a room-temperature and ambient-pressure superconducting ceramic represented by Formula 1:

<Formula 1> **AₐB_{b}(EO₄)_{c}X_{d}**

wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4.

According to one embodiment of the present invention, raw materials for the ceramic material of Formula 1 may be weighed such that the molar ratio **a:b:c:d** is in the range of 0-10:0-10:0-6:0-4.

According to a further embodiment of the present invention, raw materials for the ceramic material of Formula 1 may be weighed such that the molar ratio **a:b:c:d** is in the range of 0-10:0-10:0-6:0-4 and pretreated to synthesize a ceramic precursor.

According to another embodiment of the present invention, the ceramic material may be colored white or black.

According to another embodiment of the present invention, the ceramic material may be colored gray.

According to another embodiment of the present invention, the superconductivity of the ceramic material may be determined by the temperature-dependent magnetic susceptibility of the ceramic material.

According to another embodiment of the present invention, the superconductivity of the ceramic material may be determined by the magnetic field-dependent magnetic susceptibility of the ceramic material.

According to another embodiment of the present invention, the superconductivity of the ceramic material may be determined by the temperature-dependent current-voltage characteristics of the ceramic material.

According to another embodiment of the present invention, the superconductivity of the ceramic material may be determined by the magnetic field-dependent current-voltage characteristics of the ceramic material.

According to another embodiment of the present invention, the superconductivity of the ceramic material may be determined by the temperature-dependent resistance-temperature characteristics of the ceramic material.

According to another embodiment of the present invention, in Formula 1, **B** may substitute **A** or may be introduced in empty spaces in the crystal structure of the ceramic material.

A second aspect of the present invention provides a method for producing a superconducting ceramic represented by Formula 1:

<Formula 1> **AₐB_{b}(EO₄)_{c}X_{d}**

wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4, the method including depositing raw materials under vacuum.

According to one embodiment of the present invention, the raw materials for the ceramic material of Formula 1 may be weighed such that the molar ratio **a:b:c:d** is in the range of 0-10:0-10:0-6:0-4.

According to a further embodiment of the present invention, the deposition may be performed by heating to a reaction temperature of 550 to 2000 °C.

According to another embodiment of the present invention, the raw materials for the ceramic material of Formula 1 may be weighed such that the molar ratio **a:b:c:d** is in the range of 0-10:0-10:0-6:0-4 and pretreated to synthesize a ceramic precursor.

According to another embodiment of the present invention, the pretreatment may be performed at a reaction temperature of 550 to 1100 °C.

A third aspect of the present invention provides a method for producing a superconducting ceramic represented by Formula 1, the method including reacting lanarkite (L, Pb₂SO₅=PbO·PbSO₄) with copper phosphide (CusP).

According to one embodiment of the present invention, the reaction may be carried out at a temperature of 600 to 1000 °C.

According to a further embodiment of the present invention, the lanarkite may be prepared by weighing PbO and PbSO₄ to have its composition, mixing the weighed raw materials, and heating the mixture.

According to another embodiment of the present invention, the CusP may be synthesized by weighing Cu and P to have its composition, mixing the weighed raw materials, and heating the mixture.

Yet another aspect of the present invention provides a superconducting ceramic produced by any of the methods described herein, the superconducting ceramic being represented by Formula 1:

<Formula 1> **AₐB_{b}(EO₄)_{c}X_{d}**

wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4.

According to one embodiment of the present invention, raw materials for the ceramic material of Formula 1 may be weighed such that the molar ratio **a:b:c:d** is in the range of 0-10:0-10:0-6:0-4.

According to a further embodiment of the present invention, raw materials for the ceramic material of Formula 1 may be weighed such that the molar ratio **a:b:c:d** is in the range of 0-10:0-10:0-6:0-4 and pretreated to synthesize a ceramic precursor.

According to another embodiment of the present invention, the ceramic material may be colored white or black.

According to another embodiment of the present invention, the ceramic material may be colored gray.

According to another embodiment of the present invention, the superconductivity of the ceramic material may be determined by the temperature-dependent magnetic susceptibility of the ceramic material.

According to another embodiment of the present invention, the superconductivity of the ceramic material may be determined by the magnetic field-dependent magnetic susceptibility of the ceramic material.

According to another embodiment of the present invention, the superconductivity of the ceramic material may be determined by the temperature-dependent current-voltage characteristics of the ceramic material.

According to another embodiment of the present invention, the superconductivity of the ceramic material may be determined by the magnetic field-dependent current-voltage characteristics of the ceramic material.

According to another embodiment of the present invention, the superconductivity of the ceramic material may be determined by the temperature-dependent resistance-temperature characteristics of the ceramic material.

According to another embodiment of the present invention, **B** may substitute **A** or may be introduced in empty spaces in the crystal structure of the ceramic material.

### Effects of the Invention

The superconducting ceramic of the present invention exhibits superconductivity at room temperature and ambient pressure. The methods of the present invention are suitable for producing the superconducting ceramic.

### Brief Description of the Drawings

Fig. 1 is an image showing the shape of a superconducting ceramic according to the present invention produced by vapor deposition.
Fig. 2 is a SEM image showing the white region of the ceramic material in the image of Fig. 1.
Fig. 3 is a SEM image showing the light gray region of the ceramic material in the image of Fig. 1.
Fig. 4 is a SEM image showing the dark gray region of the ceramic material in the image of Fig. 1.
Fig. 5 is a SEM image showing the black region of the ceramic material in the image of Fig. 1.
Fig. 6 is a schematic conceptual diagram showing the colors of the regions shown in Figs. 2 to 5 and the compositions of the ceramic material in the regions as thicknesses.
Fig. 7 shows the results of XRD for a ceramic material of the present invention.
Fig. 8 shows Raman spectra of a ceramic material according to the present invention.
Fig. 9 compares Raman data obtained after background (BG) subtraction from the spectra of Fig. 8 with matched data for general apatite.
Fig. 10 shows how to determine magnetic susceptibility data for a superconducting ceramic of the present invention.
Fig. 11 shows how to determine resistance data for a superconducting ceramic of the present invention.
Fig. 12 shows how to determine I-V data for a superconducting ceramic of the present invention.
Fig. 13 shows magnetic susceptibility-temperature (M-T) data for a thin film of a superconducting ceramic according to the present invention, which were measured in a magnetic field of 0.12 Oe.
Fig. 14 shows magnetic susceptibility-temperature (M-T) data for a thin film of a superconducting ceramic according to the present invention, which were measured in a magnetic field of 10 Oe.
Fig. 15 shows data obtained after subtraction of the intrinsic diamagnetic value of the skeleton from the data shown in Figs. 13 and 14 to investigate the magnetic susceptibility value of only the superconductor.
Fig. 16 shows magnetic field (H)-dependent magnetic susceptibility data for a ceramic material of the present invention.
Fig. 17 shows an enlargement of the dotted circle of Fig. 16.
Fig. 18 shows data obtained after subtraction of linear fitting data from Fig. 16.
Fig. 19 shows temperature-dependent I-V characteristics of a ceramic material according to the present invention.
Fig. 20 shows an enlargement of the central dotted circle of Fig. 19.
Fig. 21 shows I-V characteristics of a ceramic material according to the present invention, which were measured at a low temperature.
Fig. 22 shows I-V characteristics of a ceramic material according to the present invention, which were measured while applying varying vertical magnetic fields at 300 K.
Fig. 23 shows resistances (R) of a ceramic material according to the present invention, which were measured with varying temperatures (T).
Fig. 24 shows an FE-SEM/EDX image of a sample of a ceramic material according to the present invention and location #1, #2, and #3 as numbered from left to right.
Figs. 25, 26, and 27 are SEM images taken at location #1, #2, and #3 of Fig. 24, respectively.
Fig. 28 shows FE-SEM/EDX data measured at location #1, #2, and #3 of Fig. 24.
Fig. 29 shows a structural model of a ceramic material according to the present invention in which the relationship between lead and copper is shown in two dimensions.
Fig. 30 shows a structural model of a ceramic material according to the present invention in which a three-dimensional arrangement of copper atoms is considered.
Fig. 31 shows changes in the resistance of a ceramic material according to the present invention synthesized through a solid-state reaction with varying temperatures.
Fig. 32 shows the results of XRD for a ceramic material according to the present invention synthesized through a solid-state reaction.
Fig. 33 shows I-V characteristics of a ceramic material produced in Example 1, which were measured with varying temperatures.
Figs. 34 and 35 are SEM images of ceramic materials produced in Examples 3 and 5, respectively.
Figs. 36 and 37 show changes in the I-V characteristics of ceramic materials produced in Examples 3 and 5, respectively.
Fig. 38 shows temperature-dependent superconductivity of a ceramic material produced in Example 4.
Fig. 39 shows magnetic field-dependent superconductivity of a ceramic material produced in Example 4.
Fig. 40 shows temperature-dependent R-T characteristics of a ceramic material produced in Example 4.
Fig. 41 shows FE-SEM/EDX data for a ceramic material produced in Example 4, which were measured at two random locations (#1, #2).
Fig. 42 is a photograph showing an experiment for measuring the resistance of a ceramic material produced in Example 4 in real time.

### Mode for Carrying out the Invention

The present invention will now be described in detail.

Technical terms used herein are used to merely illustrate specific embodiments and should be understood that they are not intended to limit the present invention.

As far as not being defined differently, technical terms used herein may have the same meaning as those generally understood by an ordinary person skilled in the art to which the present invention belongs, and should not be construed in an excessively comprehensive meaning or an excessively restricted meaning. If a technical term used herein is an erroneous term that fails to clearly express the idea of the present invention, it should be replaced by a technical term that can be properly understood by the skilled person in the art. In addition, general terms used herein should be construed according to definitions in dictionaries or according to its front or rear context and should not be construed in an excessively restricted meaning. As used herein, the singular forms "a," "an" and "the" are intended to include the plural forms as well, unless the context clearly indicates otherwise. The terms "comprises", "comprising", "includes" and/or "including" as used herein should not be construed to necessarily include all of the elements or steps disclosed herein, and should be construed not to include some of the elements or steps thereof, or should be construed to further include additional elements or steps. In the description of the present invention, detailed explanations of related art are omitted when it is deemed that they may unnecessarily obscure the essence of the invention.

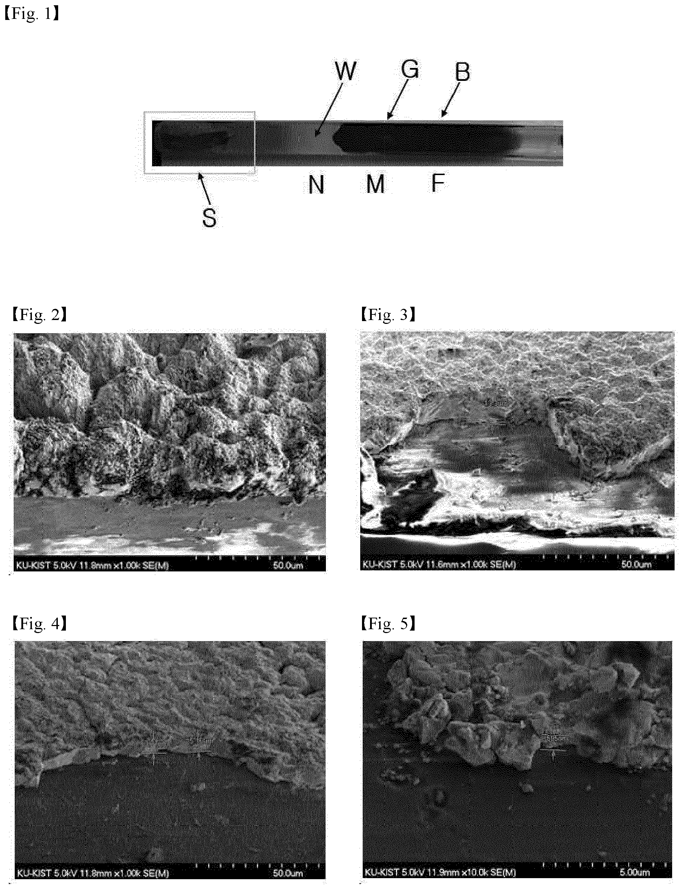

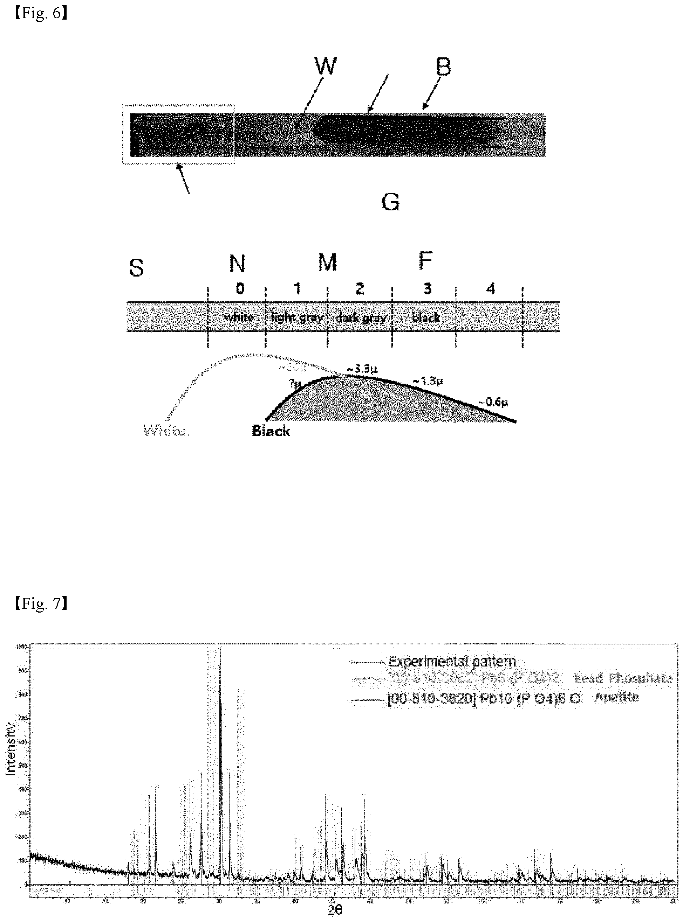

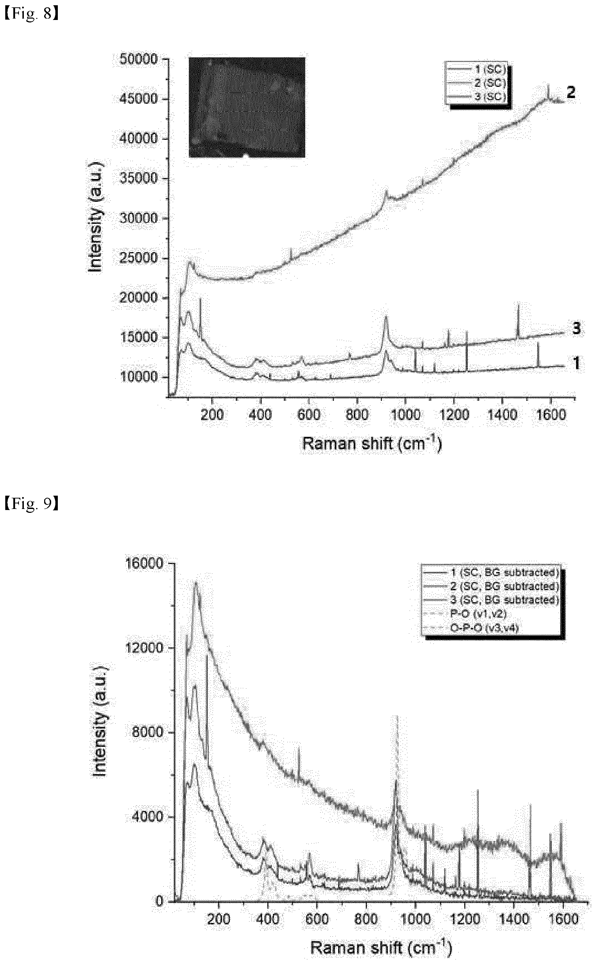

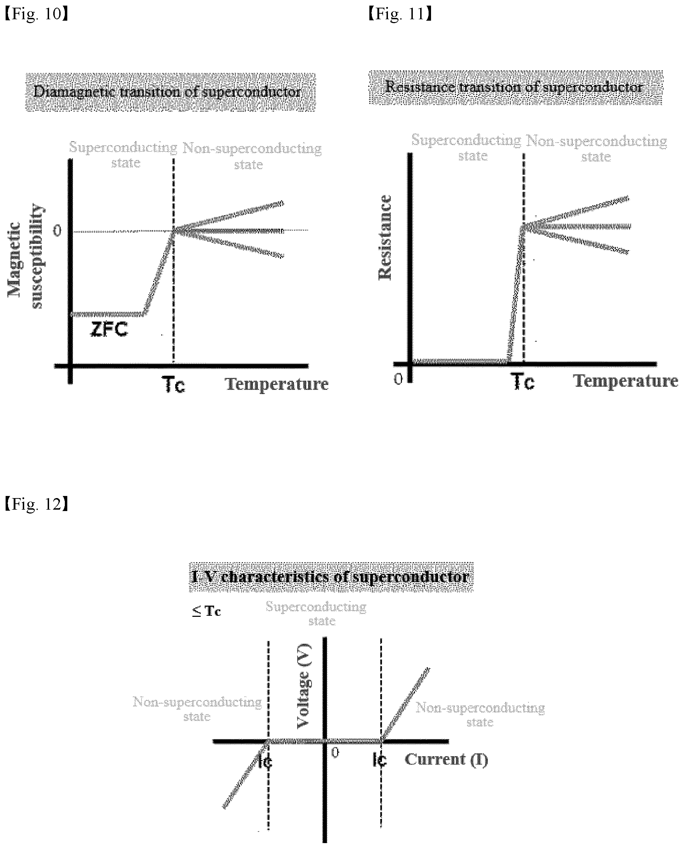

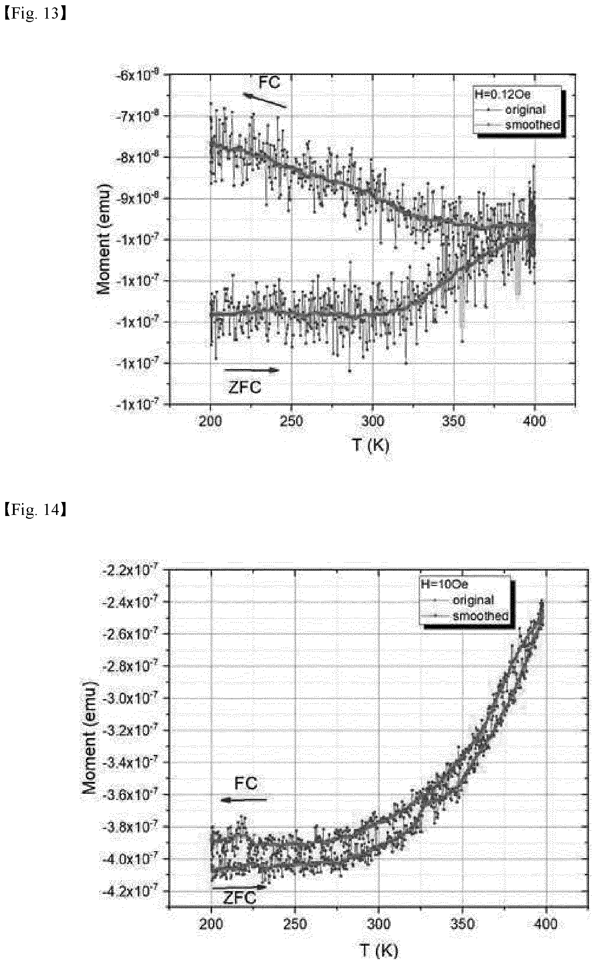

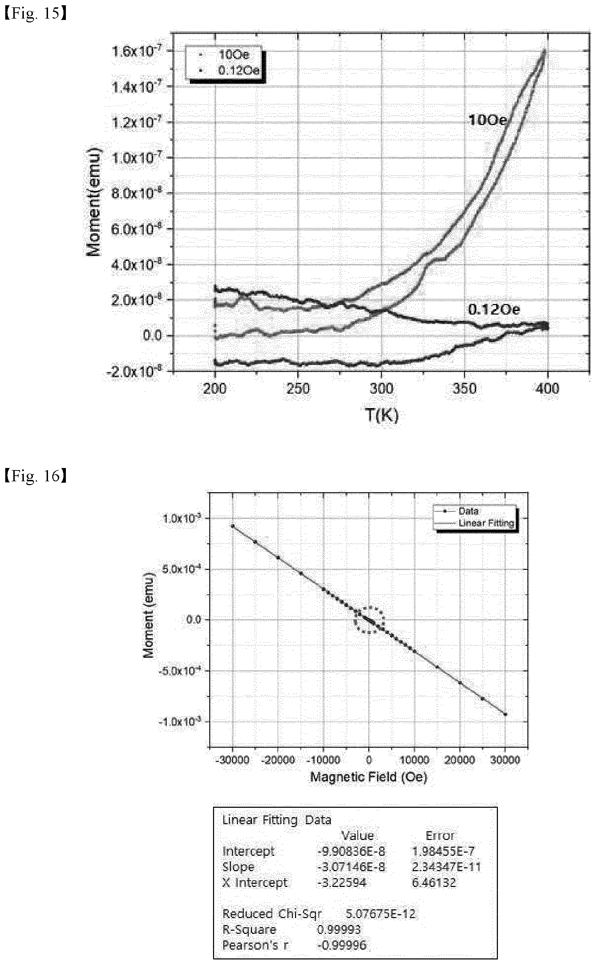

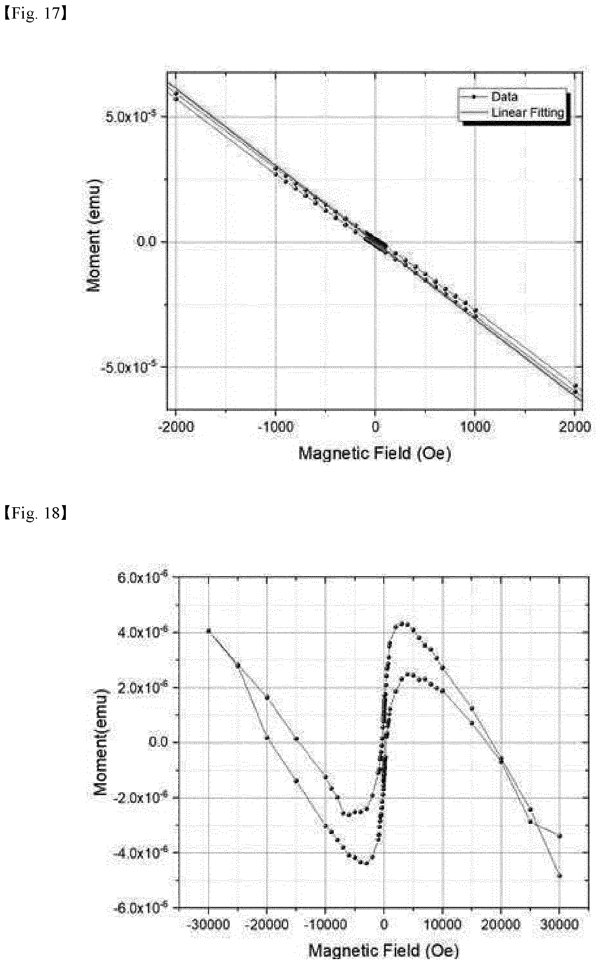

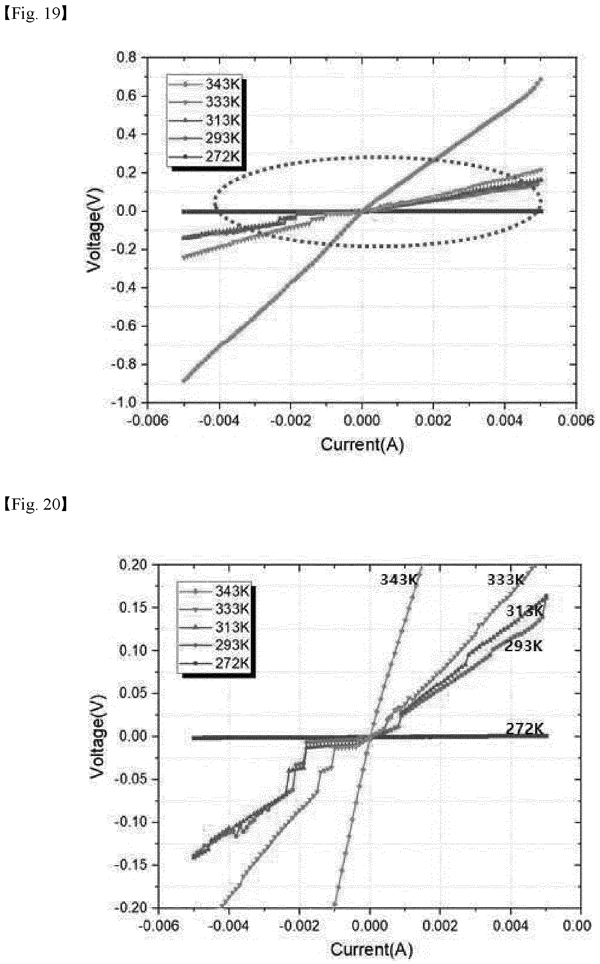

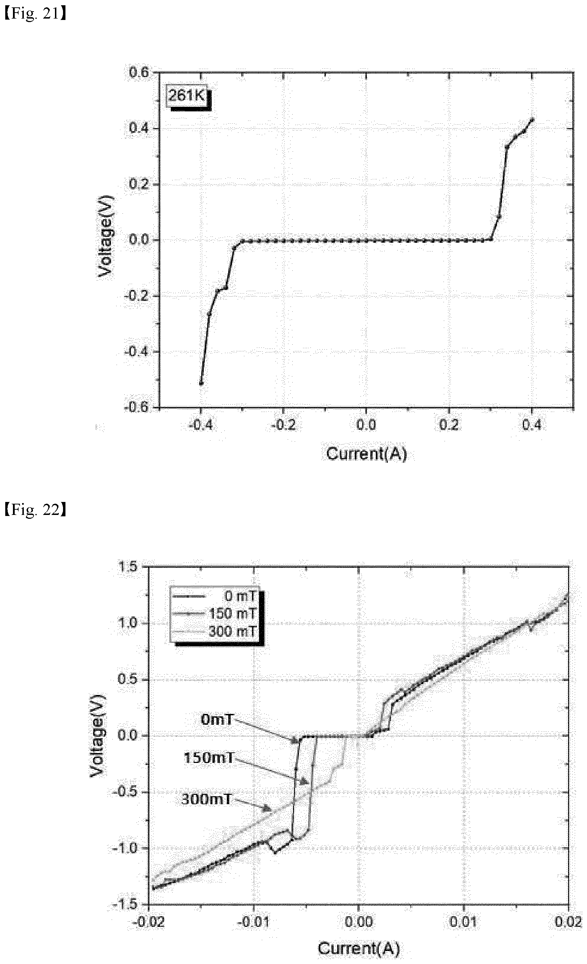

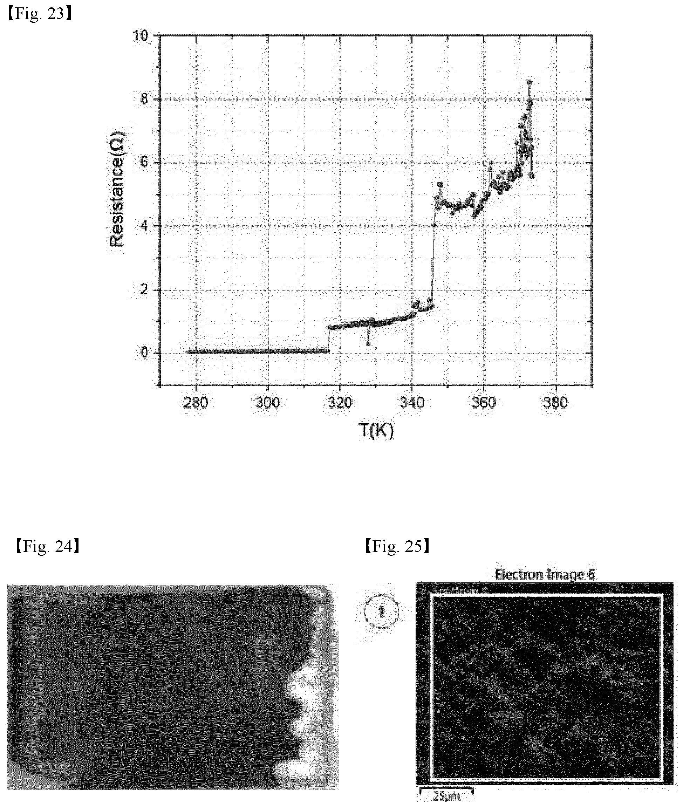

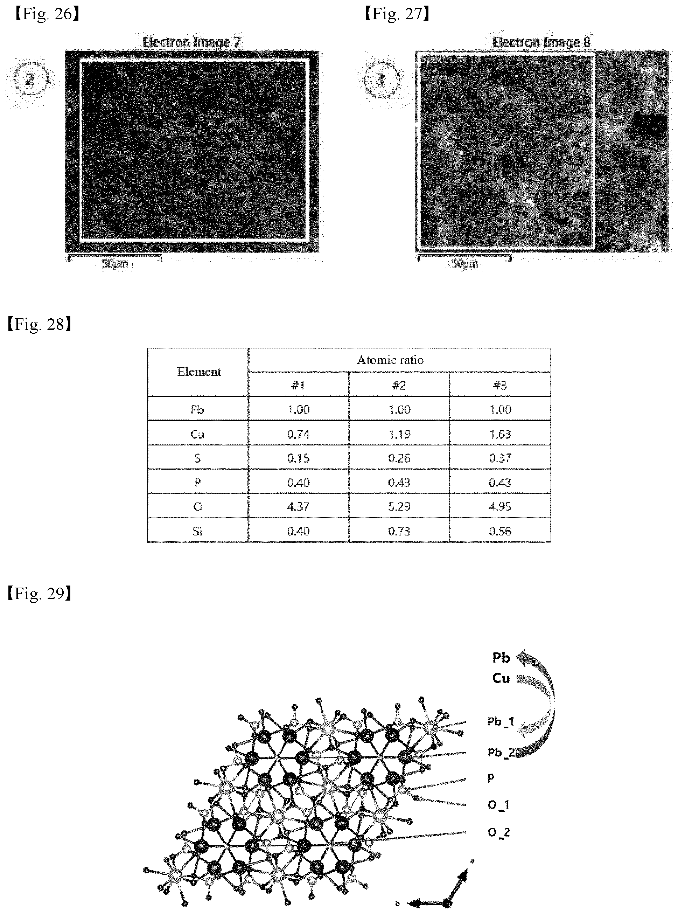

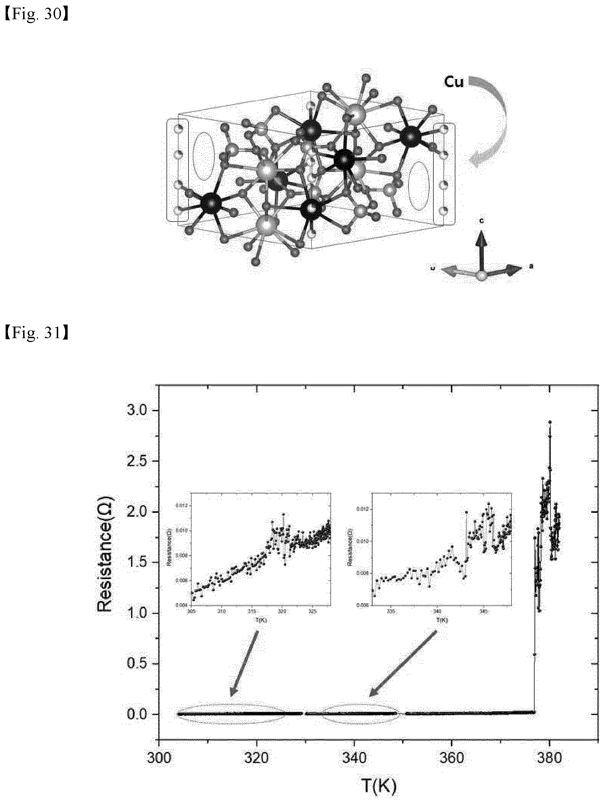

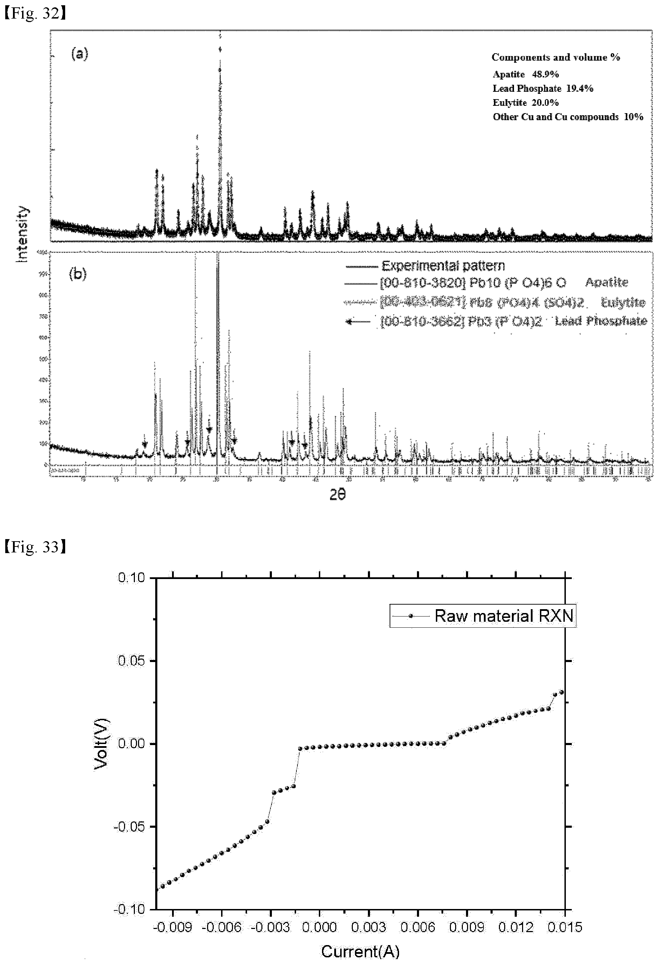

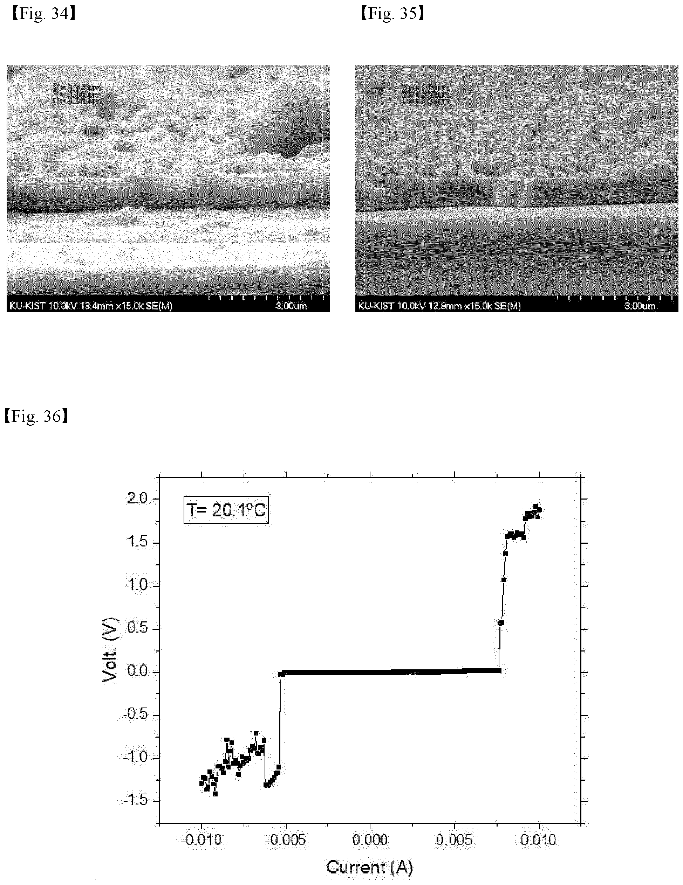

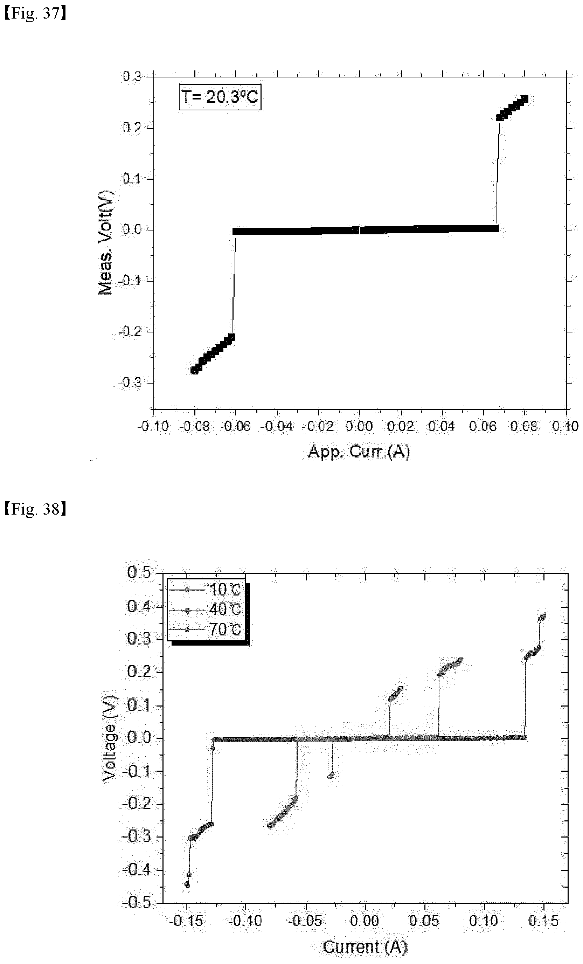

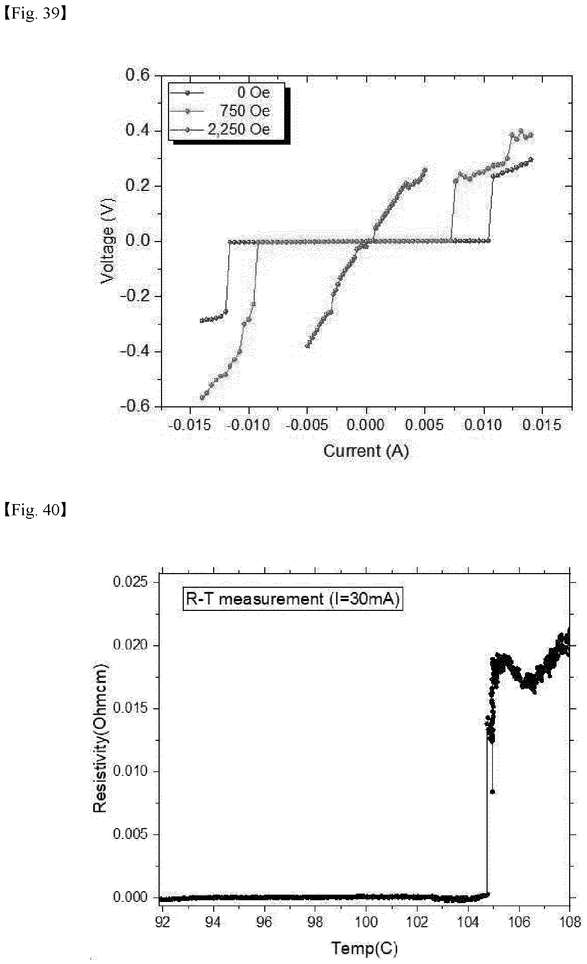

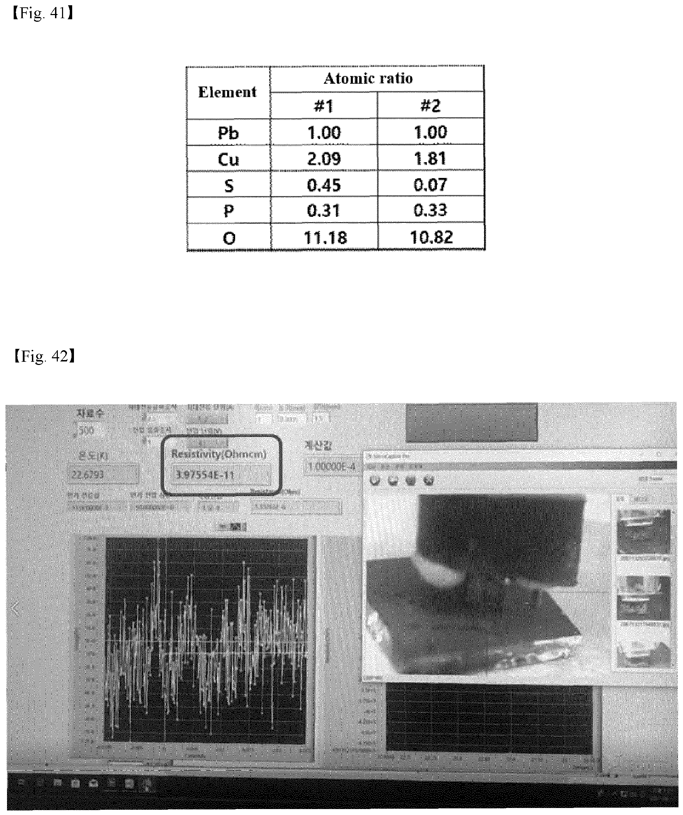

Fig. 1 is an image showing the shape of a superconducting ceramic according to the present invention produced by vapor deposition, Fig. 2 is a SEM image showing the white region of the ceramic material in the image of Fig. 1, Fig. 3 is a SEM image showing the light gray region of the ceramic material in the image of Fig. 1, Fig. 4 is a SEM image showing the dark gray region of the ceramic material in the image of Fig. 1, Fig. 5 is a SEM image showing the black region of the ceramic material in the image of Fig. 1, Fig. 6 is a schematic conceptual diagram showing the colors of the regions shown in Figs. 2 to 5 and the compositions of the ceramic material in the regions as thicknesses, Fig. 7 shows the results of XRD for a ceramic material of the present invention, Fig. 8 shows Raman spectra of a ceramic material according to the present invention, Fig. 9 compares Raman data obtained after background (BG) subtraction from the spectra of Fig. 8 with matched data for general apatite, Fig. 10 shows how to determine magnetic susceptibility data for a superconducting ceramic of the present invention, Fig. 11 shows how to determine resistance data for a superconducting ceramic of the present invention, Fig. 12 shows how to determine I-V data for a superconducting ceramic of the present invention, Fig. 13 shows magnetic susceptibility-temperature (M-T) data for a thin film of a superconducting ceramic according to the present invention, which were measured in a magnetic field of 0.12 Oe, Fig. 14 shows magnetic susceptibility-temperature (M-T) data for a thin film of a superconducting ceramic according to the present invention, which were measured in a magnetic field of 10 Oe, Fig. 15 shows data obtained after subtraction of the intrinsic diamagnetic value of the skeleton from the data shown in Figs. 13 and 14 to investigate the magnetic susceptibility value of only the superconductor, Fig. 16 shows magnetic field (H)-dependent magnetic susceptibility data for a ceramic material of the present invention, Fig. 17 shows an enlargement of the dotted circle of Fig. 16, Fig. 18 shows data obtained after subtraction of linear fitting data from Fig. 16, Fig. 19 shows temperature-dependent I-V characteristics of a ceramic material according to the present invention, Fig. 20 shows an enlargement of the central dotted circle of Fig. 19, Fig. 21 shows I-V characteristics of a ceramic material according to the present invention, which were measured at a low temperature, Fig. 22 shows I-V characteristics of a ceramic material according to the present invention, which were measured while applying varying vertical magnetic fields at 300 K, Fig. 23 shows resistances (R) of a ceramic material according to the present invention, which were measured with varying temperatures (T), Fig. 24 shows an FE-SEM/EDX image of a sample of a ceramic material according to the present invention and location #1, #2, and #3 as numbered from left to right, Figs. 25, 26, and 27 are SEM images taken at location #1, #2, and #3 of Fig. 24, respectively, Fig. 28 shows FE-SEM/EDX data measured at location #1, #2, and #3 of Fig. 24, Fig. 29 shows a structural model of a ceramic material according to the present invention in which the relationship between lead and copper is shown in two dimensions, Fig. 30 shows a structural model of a ceramic material according to the present invention in which a three-dimensional arrangement of copper atoms is considered, Fig. 31 shows changes in the resistance of a ceramic material according to the present invention synthesized through a solid-state reaction with varying temperatures, Fig. 32 shows the results of XRD for a ceramic material according to the present invention synthesized through a solid-state reaction, Fig. 33 shows I-V characteristics of a ceramic material produced in Example 1, which were measured with varying temperatures, Figs. 34 and 35 are SEM images of ceramic materials produced in Examples 3 and 5, respectively, Figs. 36 and 37 show changes in the I-V characteristics of ceramic materials produced in Examples 3 and 5, respectively, Fig. 38 shows temperature-dependent superconductivity of a ceramic material produced in Example 4, Fig. 39 shows magnetic field-dependent superconductivity of a ceramic material produced in Example 4, Fig. 40 shows temperature-dependent R-T characteristics of a ceramic material produced in Example 4, Fig. 41 shows FE-SEM/EDX data for a ceramic material produced in Example 4, which were measured at two random locations (#1, #2), and Fig. 42 is a photograph showing an experiment for measuring the resistance of a ceramic material produced in Example 4 in real time. The present invention will be described with reference to the Figs. 1 to 42.

The present invention is intended to disclose a crystal structure of a superconducting material present in a small amount, which is not disclosed in the previously filed patent application.

The present inventors have found a way to increase the amount of a superconducting material in the form of a thin film through vapor deposition (VD). The present inventors have also found a reaction mechanism and a crystal structure of the superconducting material through additional analysis. Based on these findings, the present inventors have succeeded in synthesizing the superconducting material in the form of an ingot or powder through a typical solid-state reaction.

The deposition process may be chemical vapor deposition using heat as an energy source and is not limited thereto. Any deposition process for depositing raw materials may be used without limitation. Examples of suitable deposition processes include atomic layer deposition (ALD), sputtering, thermal evaporation, e-beam evaporation, molecular beam epitaxy (MBE), and pulsed laser deposition (PLD).

As a result of repeated experiments, the present inventors have also found that the superconducting material features a mixture of two or more stable phases with different critical temperatures (Tc). This feature is similar to that of YBCO that is well known as a mixture of a phase with a critical temperature of 90 K (~-180 °C) and a phase with a critical temperature of 60 K (~-210 °C). The reason for the formation of two or more phases in the superconducting material is that a slight difference in the amount of oxygen doped causes no change in crystal structure but changes the electronic structure, leading to a change in critical temperature.

The 90 K and 60 K phases of YBCO are well formed due to their wide doping ranges. The 90 K phase of YBCO is also known to become dominant as the oxygen partial pressure increases during synthesis (https://www.researchgate.net/figure/YBCO-phase-diagram-as-a-function-of-the-oxygen-content-between6-and-7-12_fig15_33436805).

Specifically, the superconducting material of the present invention contains three main stable phases with different critical temperatures: (1) 310-320 K (-40-50 °C); (2) 340-350 K (-70-80 °C); and (3) 375-390 K (-100 -125 °C), which are hereinafter referred to as "Tc_I", "Tc_II", and "Tc_III", respectively. The critical temperatures of the phases with the same crystal structure are determined by the different electronic structures of the phases.

These three phases all have the same crystal structure but their critical temperatures are distinguished from each other by slight differences in electronic structure, as in YBCO. The ratio of the three phases varies depending on the synthesis conditions.

The slight differences in electronic structure are not discussed herein in more detail because the location of superconductivity should be accurately specified and quantum mechanical calculations fall within the scope of highly academic research.

In the Examples section that follows, a thin film of the superconducting material according to the present invention was measured for resistance and magnetic susceptibility. As a result of resistance measurements, changes in the critical temperatures of Tc_I and Tc_II were observed and no clear transition was observed in Tc_III. In contrast, changes in the critical temperatures of Tc_II and Tc_III were observed in the magnetic susceptibility measurements. The reason for the observed signal in Tc_III, which was not clear in the resistance measurements, appears to be because magnetic susceptibility measurements are more sensitive than resistance measurements.

To investigate the mechanism of a solid-state reaction in the synthesis of a thin film of the superconducting material according to the present invention, changes in the critical temperatures of Tc_I, Tc_II, and Tc_III were observed. As a result, the largest change was observed in Tc_III and smaller changes were found in Tc_I and Tc_II, indicating a significantly increased amount of Tc_III.

More detailed descriptions of the Tc_I, Tc_II, and Tc_III regions will be provided below.

Specifically, the present invention provides a superconducting ceramic represented by Formula 1:

<Formula 1> **AₐB_{b}(EO₄)_{c}X_{d}**

wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4.

The ceramic material of Formula 1 and apatite have different physical properties and characteristics despite their structural similarity. The structure of the ceramic material of Formula 1 is herein referred to as "LK99".

Apatite is a mineral in which metal atoms are bonded to phosphate groups. Apatite has long been commonly used as a dye. Apatite is an electrical insulator with a large energy gap, while LK99 acts as an electrical conductor (particularly a superconductor) because it contains substituents or dopants and defects capable of creating a new energy level.

**A, E,** and **X** in Formula 1 are general constituents of apatite (https://www.intechopen.com/books/apatites-and-their-synthetic-analogues-synthesis-structure-properties-and-applications/introduction-to-apatites). **B** in Formula 1 is an element with d-orbitals as a kind of substituent or dopant and enables conversion from an insulator to a conductor or superconductor.

More specifically, **A** in Formula 1 is Ca, Ba, Sr, Sn or Pb that has the characteristics of an s- or p-block metal, Y, La or Ce as an element of the lanthanide series or a combination thereof.

In Formula 1, **B** is Cu, Cd, Zn, Mn, Fe, Ni or Ag that has the characteristics of a d-block metal or a combination thereof, **E** is P, As, V, Si, B, S or a combination thereof, and **X** is F, Cl, OH, O, S, Se, Te or a combination thereof.

In Formula 1, **a** is 0 to 10, **b** is 0 to 10, c is 0 to 6, and **d** is 0 to 4. As used herein, the number "0" refers to the possible presence of a very small amount (*e.g*., 10⁻¹⁰ g) of the corresponding element or group rather than nothing.

The ceramic material represented by Formula 1 can be synthesized by weighing raw materials for **AₐB_{b}(EO₄)_{c}X_{d}** (Formula 1) such that the molar ratio **a:b:c:d** is in the range of 0-10:0-10:0-6:0-4 and allowing the raw materials to react in a vacuum-controlled reaction vessel at a temperature of 550 to 2000 °C for 1 to 100 hours for deposition.

The raw materials may be pretreated for effective, dense and uniform vapor deposition. This pretreatment is performed by weighing raw materials for **AₐB_{b}(EO₄)_{c}X_{d}** (Formula 1) such that the molar ratio **a:b:c:d** is in the range of 0-10:0-10:0-6:0-4 and allowing the raw materials to react in a vacuum-controlled reaction vessel at a temperature of 550 to 1100 °C for 10 to 100 hours. The resulting ceramic precursor can be used as a raw material for deposition.

In the present invention, the processing temperature and time conditions are set to (1) 550-1100 °C and 10-100 hours for the synthesis of the ceramic precursor and (2) 550-2000 °C and 0.5-100 hours for the subsequent vapor deposition. The reason for these conditions is that stable reaction conditions (including a relatively low temperature (550-1100 °C)) are primarily established depending on the desired composition to allow the reaction to proceed in a well-mixed solid solution and the resulting ceramic precursor is used as a raw material for the subsequent vapor deposition.

If the heating temperature for the synthesis of the ceramic precursor is lower than 550 °C, sufficient mixing may not take place, with the result that the desired reaction does not occur sufficiently. Meanwhile, if the heating temperature exceeds 1100 °C, the composition may be changed and other reactions may occur, making it impossible to obtain the desired composition and causing a waste of energy. If the heating time is shorter than 10 hours, the desired reaction does not occur sufficiently, like when the heating temperature is low. Meanwhile, if the heating time exceeds 100 hours, too much energy may be consumed.

The deposition may be carried out largely by two processes: chemical vapor deposition (CVD) and physical vapor deposition depending on the deposition conditions. According to chemical vapor deposition (CVD), a well-prepared sample (including the pretreated material) is placed on a heating element under vacuum and is vaporized by heating with an energy source. If the heating temperature is lower than 550 °C, the raw materials needing to be gassed are hardly vaporized. Meanwhile, if the heating temperature exceeds 2000 °C, the temperature of the deposition surface may rise excessively, making it difficult to form the desired deposition phase. If the heating time is shorter than 0.5 hours, the raw materials may not be sufficiently vaporized, leading to a small deposition thickness. Meanwhile, if the heating time exceeds 100 hours, energy may be wasted after completion of the deposition.

Physical vapor deposition includes thermal evaporation at 550 to 2000 °C. If the deposition temperature is lower than 550 °C, the elements may not be sufficiently vaporized, making it difficult to uniformly produce the final material. Meanwhile, if the deposition temperature exceeds 2000 °C, the superconducting material may be difficult to produce. If the heating time is shorter than 0.5 hours, the raw materials may not be sufficiently vaporized, leading to a small deposition thickness. Meanwhile, if the heating time exceeds 100 hours, energy may be wasted after completion of the deposition.

Since heating is required during synthesis of the ceramic material according to the present invention, a temperature gradient is generated in a layer or domain of the product, for example, during natural cooling, after the passage of some time. A deposition film may also be formed in a specific temperature range (100-400 °C). A white film is formed in a high temperature region and a black film is formed in a low temperature region. In a middle temperature region, both a white film and a black film are formed and appear to be colored gray. The colored ceramic material exhibits superconductivity, particularly strong electrical properties unique to superconductors in the gray region, indicating that it is produced in an amount sufficient for percolation. Fig. 1 is an image showing the shape of the inventive superconducting ceramic produced by vapor deposition. Referring to Fig. 1, the region (N) is near the heating source (S) for heating the raw materials and is colored white (W), the region (F) is far from the heating source (S) and is colored black (B), and the middle region (M) is colored gray (G).

The relationship between the inventive ceramic material and the colors such as white, black, and gray was investigated through scanning electron microscopy (SEM) images. Figs. 2 to 5 are SEM images of the ceramic material taken at an oblique angle of ~45°. Specifically, Fig. 2 is a SEM image showing the white region of the ceramic material, Fig. 3 is a SEM image showing the light gray region of the ceramic material, Fig. 4 is a SEM image showing the dark gray region of the ceramic material, and Fig. 5 is a SEM image showing the black region of the ceramic material.

These color expressions are associated with the compositions of the ceramic material in the colored regions. Lanarkite (Pb₂SO₅) and PbS appear to be dominant in the white and black regions, respectively.

It is believed that evaporated PbS reacts with oxygen from a substrate to form lanarkite, as depicted below:

2PbS (s) + 5/2O₂ (s, from substrate) → Pb₂SO₅ (s) + S (g)f

Fig. 6 is a schematic conceptual diagram showing the colors of the regions shown in Figs. 2 to 5 and the compositions of the ceramic material in the regions as thicknesses. As shown in Fig. 6, the region (N) near the heating source (S) for heating the raw materials is colored white (W) and has a thickness of about 30 µm, the region (F) far from the heating source (S) is colored black (B) and has a thickness of about 0.6 µm, and the middle region (M) is colored light charcoal (G) including both a 1.3-3.3 µm thick black region and a 4-30 µm thick white region. A determination of whether the color expressions are due to simple mixing of the different colors of the ceramic material or changes in the composition of the ceramic material will be described below.

This composition can be explained by X-ray diffraction (XRD) for crystal structure analysis. Fig. 7 shows the results of XRD for the inventive ceramic material, particularly in the gray region (M) (the dark gray 2 of Fig. 6) where superconductivity is exhibited. In Fig. 7, the black line is based on the experimental pattern and is drawn by matching the dark line (for apatite) and the light line (for lead phosphate) based on the crystallography open database (COD).

The black line is, on the whole, in good agreement with the dark line, which represents apatite, a type of phosphate mineral, despite slight deviations in the peak positions. The light line represents lead phosphate that is formed in a small amount as a byproduct in the synthesis of the inventive ceramic material.

Fig. 7 reveals that the major constituent of the ceramic material has a similar structure to apatite. Apatite is a white or slightly colored electrical insulator and is not a conductor or superconductor, unlike the ceramic material (LK99).

Raman spectroscopy was performed for three randomly selected points in the gray region (M) (the dark gray 2 of Fig. 6), where the superconductivity of the inventive ceramic material were clearly exhibited, to determine the presence or absence of phosphate groups. Fig. 8 shows Raman spectra of the inventive ceramic material. 1, 2, and 3 in the image at the top left of Fig. 8 represent the measured points.

Fig. 9 compares Raman data obtained after background (BG) subtraction from the spectra of Fig. 8 with matched data for general apatite. In Fig. 9, v1, v2, v3, and v4 represent the vibrational modes of the phosphate group (PO₄) (v1: symmetric stretching, v2: symmetric bending, v3: antisymmetric stretching, v4: antisymmetric bending). Fig. 9 reveals that the inventive ceramic material has phosphate groups.

Descriptions of the Tc_I, Tc_II, and Tc_III regions will be continued below. As can be seen from Figs. 10, 11, and 12, it is necessary to explain how to determine whether the ceramic material is a superconductor.

That is, whether the ceramic material is a superconductor can be determined largely by measuring two characteristics: 1) magnetic susceptibility (magnetic moment) and 2) resistance or current-voltage (I-V) data.

Fig. 10 shows how to determine magnetic susceptibility data for the superconducting ceramic. A transition occurs in which the magnetic susceptibility of the superconducting ceramic suddenly increases when the temperature rises above the critical temperature (Tc). This measurement is called zero-field cooling (ZFC). Measurement of magnetic susceptibility with decreasing temperature is called field cooling (FC), which will be explained in detail in the magnetic susceptibility measurement section that follows.

Fig. 11 shows how to determine resistance data for the inventive superconducting ceramic. A transition occurs in which the resistance of the superconducting ceramic suddenly decreases (theoretically drops to zero (0)) when the temperature falls below the critical temperature (Tc). The same data are obtained even when the temperature rises from a low value to a value above the critical temperature.

As can be seen from Figs. 10 and 11, the ceramic material loses its superconductivity above the critical temperature, resulting in various patterns depending on its inherent characteristics.

Fig. 12 shows how to determine I-V data for the inventive superconducting ceramic. The data are obtained by measuring voltages applied to both ends when a current is applied from a negative (-) value to positive (+) value at a temperature below the critical temperature (Tc). When a current flows below the critical current (from -Ic to +Ic), a voltage of "0 V" is detected, indicating superconductivity of the ceramic material. At a current above the critical current, the ceramic material is in a non-superconducting state and follows the Ohm's law, like general materials.

Figs. 13 and 14 show magnetic susceptibility-temperature (M-T) data for a thin film of the inventive superconducting ceramic, which were measured in magnetic fields of 0.12 Oe and 10 Oe, respectively. The M-T data were measured by vibrating sample magnetometry (VSM) in the temperature range of 200 K to 400 K. The VSM measurements have an advantage in that even very small signals from samples can be detected, but with a low S/N ratio.

For convenience of understanding, smoothed data in addition to the original data are shown in Fig.15.

Zero-field cooling (ZFC) and field cooling (FC) are typical measurements for determining the Meissner effect, which refers to the occurrence of diamagnetism in superconductors. The Meissner effect can be determined by various methods, specifically including 1) a method in which the temperature of a sample is lowered under an external magnetic field of 0 and the magnetic susceptibility is measured while raising the temperature under a constant applied magnetic field (ZFC), 2) a method in which the magnetic susceptibility is measured while lowering the temperature again in a state in which the applied magnetic field is maintained (FC), and 3) a method in which a determination is made as to whether ZFC and FC are different and the sample undergoes a diamagnetic transition below the critical temperature under ZFC unless the sample is a type 1 superconductor such as a simple metal element.

Since the ceramic material of the present invention has the intrinsic diamagnetism of the constituent skeleton (including phosphate groups, silicate groups, sulfate groups, etc.) other than the moiety where superconductivity occurs, it exhibits a combination of (1) the diamagnetism of a superconductor and (2) the intrinsic diamagnetism.

That is, a diamagnetic transition occurs in which (1) increases below the critical temperature but this transition is not observed in (2). In response to a change in external magnetic field, hysteresis is observed in (1) but no hysteresis is observed in (2). When a strong external magnetic field is applied, (1) is weakened or destroyed but (2) is increased proportionally.

In addition to (1) and (2), (3) ferromagnetism newly occurs between (1) and (2). The cause of the new ferromagnetism has not yet been elucidated but the present inventors consider it as a proximity effect.

When magnetism other than superconductivity is combined, its influence should be minimized to observe a diamagnetic transition in the superconductor only. This is experimentally possible by minimizing the magnitude of an external magnetic field applied to measure magnetic susceptibility. The data shown in Fig. 13 were obtained after the application of a magnetic field of 0.12 Oe (only a SQUID magnetometer with a lowfield option can be used to control magnetic fields at this level). The data shown in Fig. 14 were obtained after the application of a magnetic field of 10 Oe.

Fig. 15 shows data obtained after subtraction of the intrinsic diamagnetic value of the skeleton from the data shown in Figs. 13 and 14 to investigate the magnetic susceptibility value of only the superconductor. The intrinsic diamagnetic value of the skeleton was calculated from the linear fitting data on the magnetic susceptibility (magnetic moment) at 0.12 Oe and 10 Oe (-1.03×10⁻⁷ emu at 0.12 Oe, -4.06×10⁻⁷ emu at 10 Oe).

Referring to Figs. 13 to 15, under ZFC, a diamagnetic transition primarily began around Tc_III, a change in slope corresponding to a secondary transition was observed also in Tc_II (indicated by the yellow arrow), the magnetic susceptibility value was a negative number (diamagnetism), the critical temperature was decreased to approximately -325 K by an increase in external magnetic field, and the magnetic susceptibility value was already positive (affected by ferromagnetism).

Next, the magnetic susceptibility values of the inventive ceramic material were measured with varying magnetic fields (H). The magnetization measurement was performed using a SQUID-vibration sample magnetometer (Quantum Design MPMS3). The measured data are also called "M-H data".

Fig. 16 shows magnetic field (H)-dependent magnetic susceptibility data for the inventive ceramic material, Fig. 17 shows an enlargement of the dotted circle of Fig. 16, and Fig. 18 shows data obtained after subtraction of linear fitting data from Fig. 16. Referring to these figures, (a) when M-H hysteresis was measured between -3T and +3T, diamagnetism of the apatite skeleton without hysteresis was overall observed. Linear fitting was performed to obtain the diamagnetism value of the skeleton (the fitting data are shown in Fig. 16). (b) Hysteresis was observed in the enlargement of the central dotted circle. This hysteresis was not found in the strong magnetic field region and is not due to the skeleton but is believed to be due to a combination with superconductivity in the low magnetic field region. (c) Ferromagnetism was detected by subtraction of the linear fitting data from (a). The ferromagnetism is the same as that described previously and a description thereof is herein omitted.

The current-voltage (I-V) characteristics of the inventive ceramic material were measured with varying temperatures to explain the electrical properties of the ceramic material.

Fig. 19 shows temperature-dependent I-V characteristics of the inventive ceramic material, which were measured by a 4-probe method using probes spaced 1 mm apart from each other. The I-V characteristics of the sample were observed for several sections of the sample between 272 K and 343 K. As a result, patterns unique to superconductors could be observed.

Fig. 20 shows an enlargement of the central dotted circle of Fig. 19, where superconductivity could be observed. The curves are asymmetric about "0", which is believed to be due to non-uniformity of the thin film sample. For example, the non-uniformity is caused by thickness deviations and the presence of non-superconducting materials acting as Josephson junctions.

Fig. 21 shows I-V characteristics of the inventive ceramic material, which were measured at a low temperature of 261 K. Fig. 21 reveals that the increased symmetry of the curve at the low temperature led to a significant reduction in asymmetry. This I-V asymmetry is also called I-V hysteresis and has various causes. The minimum resistivity value was 10⁻⁷ Ω·cm but it is believed that as the size of the ceramic material increases, the symmetry of the curve will increase due to the presence of residual resistance.

The reason for this is that when a smaller size of the particles leads to more grain boundaries between the particles, which is responsible for the residual resistance.

The I-V characteristics of the inventive ceramic material were measured with varying magnetic fields to explain the electrical properties of the ceramic material. Fig. 22 shows I-V characteristics of the inventive ceramic material, which were measured while applying varying vertical magnetic fields at 300 K. The measurements were performed by a 4-probe method using a KEITHLEY 228A power (voltage/current) source and a KEITHLEY 182 sensitive digital voltmeter. As shown in Fig. 22, superconductivity was clearly observed where the critical current range decreased as the magnetic field increased at a constant temperature below the critical temperature.

Fig. 23 shows resistances (R) of the inventive ceramic material, which were measured with varying temperatures (T). The measurements were performed by a 4-probe method using a KEITHLEY 228A power (voltage/current) source and a KEITHLEY 182 sensitive digital voltmeter. As described previously, the inventive ceramic material contains three phases with different critical temperatures ((1) Tc_I (310 -320 K (~40-50 °C)), (2) Tc_II (340-350 K (~70-80 °C), and (3) Tc_III (375-390 K (~100-125 °C)) due to its superconductivity. The Tc_I and Tc_II phases are confirmed in Fig. 23. A sudden pattern change corresponding to a transition was not observed and only a broadly decreasing trend (not shown) was observed in the Tc_III region. In magnetic susceptibility measurements with higher sensitivity, the Tc_III region was also observed (a diamagnetic transition primarily began around Tc_III in the ZFC mentioned above).

A further discussion will be made of a solid-state reaction for the synthesis of the inventive ceramic material.

First, the composition of the inventive ceramic material was analyzed by FE-SEM/EDX. The results are shown in Figs. 24 to 27.

Fig. 24 shows an FE-SEM/EDX image of a sample of the inventive ceramic material and location #1, #2, and #3 as numbered from left to right. SEM images taken at location #1, #2, and #3 of Fig. 24 are shown in Figs. 25, 26, and 27, respectively.

Fig. 28 shows FE-SEM/EDX data to determine the compositions of the sample at the different locations. Specifically, Fig. 28 is a table comparing the atomic ratios (%) of the corresponding elements to lead (Pb) as the central metal.

This table shows the proportions of lead (Pb), copper (Cu), sulfur (S), phosphorus (P), oxygen (O), and silicon (Si) measured at location #1, #2, and #3. The weight ratio of lead to phosphorus (Pb:P) in apatite is 1:0.6, whereas that in the inventive ceramic material was ~1:0.4.

These results demonstrate that some of the phosphorus (P) atoms in apatite were substituted with one or more other elements (for example, P=~0.4, S=~0.2).

It is also believed that copper (Cu) atoms partially replaced Pb sites in apatite or were partially arranged as dopants in the structure to form LK99. Modeling of LK99 was performed and the results are shown in Figs. 29 and 30.

Fig. 29 shows a structural model of the inventive ceramic material in which the relationship between lead and copper is shown in two dimensions and Fig. 30 shows a structural model of the inventive ceramic material in which a three-dimensional arrangement of copper atoms is considered. Referring to Figs. 29 and 30, sites where Cu atoms are introduced can be modeled in two ways. The first is to substitute lead (Pb) with copper (Cu) (see Fig. 29). Referring to Fig. 29, the lead substitution may occur at Pb_1 and/or Pb_2 sites. The second is that copper (Cu) is introduced in empty spaces in the structure (see Fig. 30). Referring to Fig. 30, copper (Cu) is introduced in oval spaces between overlying and underlying Pb_2 sites and/or rectangular spaces where some O_2 sites leave and Cu atoms occupy the vacancies or between adjacent O_2 sites.

Although not shown in these figures, sulfur (S) atoms replace some of the phosphorus (P) sites.

Analysis of the inventive ceramic material reveals some features of the superconducting material: (1) the superconducting material is produced where lanarkite is present; (2) both Cu and P are detected in the superconducting material; (3) Cu and P form CusP, which is found in the database (COD); and (4) therefore, the reaction of lanarkite with CusP leads to the production of 'LK99', which is the structure of the inventive superconducting ceramic. This reaction is depicted below:

<Reaction scheme> **L** + **Cu₃P → LK99**

where L represents lanarkite (Pb₂SO₅=PbO·PbSO₄).

The reaction scheme explains the mechanism of the reaction for producing the inventive ceramic material. The structure of apatite does not have only sulfate groups but has only phosphate groups or both phosphate and sulfate groups. Lanarkite is a sulfate compound. When lanarkite reacts with CusP, some or all of the sulfur atoms are replaced with phosphorus atoms to form phosphate groups.

The reaction for the synthesis of the inventive ceramic material is a solid-state reaction. Specifically, the inventive ceramic material is synthesized by the following procedure.

First, a PbO powder is homogenized with a PbSO₄ powder in a 1:1 molar ratio, the mixture is placed in an alumina crucible and put in a furnace, and the reaction is allowed to proceed at 725 °C for 24 hours to synthesize lanarkite. After completion of the reaction, the lanarkite is ground and stored in a vial.

Next, a Cu powder is homogenized with a P powder in the predetermined ratio, the mixture is placed in a quartz tube as a reaction tube, the reaction tube is evacuated and sealed, and the reaction is allowed to proceed at 550 °C for 48 hours to prepare CusP. After completion of the reaction, the reaction product is taken out of the tube and the resulting ingot is ground and stored in a vial.

Next, the lanarkite is homogenized with the CusP in a 1:1 molar ratio, the mixture is placed in a reaction tube, the reaction tube is evacuated and sealed, and the reaction is allowed to proceed at 600 to 1000 °C for 5 to 40 hours to prepare the inventive ceramic material. If the reaction temperature is lower than 600 °C, sufficient reaction energy is not supplied. Meanwhile, if the reaction temperature exceeds 1000 °C, SO₄ present in the lanarkite may be decomposed. After completion of the reaction, the reaction product is taken out of the tube and used as a sample. The resulting ingot may be processed or ground and stored, as needed.

The electrical properties and structural features of the inventive ceramic material synthesized based on the solid-state reaction can be confirmed with reference to Figs. 31 and 32.

The ingot formed by the solid-state reaction was processed into a rectangular shape. Changes in the resistance of the sample were measured with varying temperatures from 304 to 382 K and are shown in Fig. 31. The measurements were performed by the same method as described above for the measurements of electrical properties.

The overall largest transition was observed in Tc_III at 377 K (∼104 °C). No clear transitions were visible in Tc_I and Tc_II, but changes were observed in Tc_I and Tc_II at 315 K (~422 °C) and 343 K (~70 °C) when the corresponding temperature regions were enlarged. It is believed that the Tc_III phase was the most abundant and the Tc_I and Tc_II phases were partially mixed.

Fig. 32 shows (a) the results of XRD for the ingot synthesized through the solid-state reaction and (b) the results of matching with COD for comparison with the XRD data for the ceramic material synthesized by vapor deposition. Interestingly, a eulytite structure was observed as a byproduct in the ingot synthesized through the solid-state reaction and was not visible in the deposition product. This difference is believed to be because eulytite has a similar composition to LK99 in that both phosphate and sulfate groups are present. Eulytite exhibits insulating properties, which appears to be because copper (Cu) as a dopant is not introduced therein. Since eulytite is an electrical insulator with a large energy gap, substituents or dopants and defects capable of creating a new energy level are required to make eulytite electrically conductive, especially superconductive. The reason why eulytite is an electrical insulator with a large energy gap is because eulytite is an ionic material whose total oxidation number is zero, like apatite. An ionic material is a transparent crystal (or a white powder) or lightly colored electrical insulator due to its inherently large energy gap, which explains that eulytite is an electrical insulator.

In order to investigate how much volume each byproduct occupies, the volume proportion (%) of the byproduct was calculated using MAUD, a Rietveld software. The values are shown in (a) of Fig. 32, where the dotted and solid lines denote the experimental and calculated values, respectively. The reason for the calculation of the volume proportions is that when a superconductor and a non-superconductor are mixed and the volume proportion of the superconductor exceeds a predetermined threshold, the superconductor particles are percolated to exhibit an I-V transition or R-T transition, which demonstrates their superconductivity. Apatite takes up almost half (48.9%) of the volume of the inventive ceramic material synthesized through the solid-state reaction, explaining the superconductivity of the ceramic material.

### Example 1. Synthesis by vapor deposition

The following procedure was carried out to synthesize the inventive ceramic material represented by **AₐB_{b}(EO₄)_{c}X_{d}** (Formula 1). First, Pb, Cu, P, and S were weighed in a molar ratio of **a:b:c:d** = 0-10:0-10:0-6:0-4 to a total of 3 g. Pb, Cu, and P were purchased from DAEJUNG and S was purchased from JUNSEI. All elements were EP grade. The mixture was placed in a quartz tube. The quartz tube was evacuated to 10⁻⁵ Torr with a vacuum pump and put in a furnace chamber while maintaining the vacuum. The mixture was evaporated and deposited at a reaction temperature of 550-2000 °C for a reaction time of 0.5-100 h to synthesize the inventive ceramic material.

### Example 2. Synthesis by vapor deposition

The following procedure was carried out to synthesize the inventive ceramic material represented by **AₐB_{b}(EO₄)_{c}X_{d}** (Formula 1). First, Pb, Cu, P, and S were weighed in a molar ratio of **a:b:c:d** = 0-10:0-10:0-6:0-4 to a total of 3 g. The mixture was placed in a quartz tube. The quartz tube was evacuated to 10⁻⁵ Torr with a vacuum pump. The vacuum was maintained for 20 min. Thereafter, the tube was allowed to extend a total length of 15 cm, sealed with a torch, and put in a furnace chamber. The mixture was allowed to react at a temperature of 550-1100 °C for a time of 10-100 h to synthesize a ceramic precursor. The subsequent procedure was carried out in the same manner as in Example 1, except that the ceramic precursor was used as a raw material for deposition.

### Example 3. Synthesis by vapor deposition

The following procedure was carried out to synthesize the inventive ceramic material represented by **AₐB_{b}(EO₄)_{c}X_{d}** (Formula 1). First, Pb, Cu, P, and S were weighed in a molar ratio of **a:b:c:d** = 0-10:0-10:0-6:0-4 to a total of 3 g. The mixture was placed in a quartz tube. The quartz tube was evacuated to 10⁻⁵ Torr with a vacuum pump. The vacuum was maintained for 20 min. Thereafter, the tube was allowed to extend a total length of 15 cm, sealed with a torch, and put in a furnace chamber. The mixture was allowed to react at a temperature of 550-1100 °C for a time of 10-100 h to synthesize a ceramic precursor. The ceramic precursor was loaded as a raw material on a substrate, arranged in a vacuum chamber, and placed on a tungsten boat as a heating element, liquefied while maintaining a vacuum of ≤ 10⁻⁵ Torr and the temperature of the heating element at ~550-900 °C for ~1-5 min, heated to 900-2000 °C, and vaporized for deposition on the surface of a high-purity glass plate arranged in the path of an ascending gas.

### Example 4. Synthesis by solid-state reaction

A PbO powder was homogenized with a PbSO₄ powder in a 1:1 molar ratio, the mixture was placed in an alumina crucible and put in a furnace, and the reaction was allowed to proceed at 725 °C for 24 h to synthesize lanarkite. After completion of the reaction, the lanarkite was ground. Next, a Cu powder was homogenized with a P powder in the predetermined ratio, the mixture was placed in a quartz tube as a reaction tube, the reaction tube was evacuated and sealed, and the reaction was allowed to proceed at 550 °C for 48 h to prepare Cu₃P. After completion of the reaction, the reaction product was taken out of the tube. The resulting ingot was ground. Next, the lanarkite was homogenized with the CusP in a 1:1 molar ratio, the mixture was placed in a reaction tube, the reaction tube was evacuated and sealed, and the reaction was allowed to proceed at 600 -1000 °C for 5-40 h to synthesize the inventive ceramic material. After completion of the reaction, the resulting ingot was taken out of the tube and used as a sample. The PbO, PbSO₄, Cu, and P used for the solid-state reaction were purchased from JUNSEI, KANTO, DAEJUNG, and JUNSEI, respectively. The PbO and PbSO₄ were GR grade and the Cu and P were EP grade.

### Example 5. Synthesis by vapor deposition

The procedure of Example 3 was repeated except that the material synthesized through a solid-state reaction in Example 4 was used as a raw material.

### Experimental Example 1. Colors and micrographs (scanning electron microscopy (SEM) images)

As shown in Fig. 1, the ceramic material produced in Example 2 had a white color (W) in the region (N) near the heating source (S) for heating the raw materials, a black color (B) in the region (F) far from the heating source (S), and a gray color (G) in the middle region (M).

The images of Figs. 2 to 5 reveal the uniform formation of fine structures in the white, black, and gray regions at 50 µm.

Figs. 34 and 35 show SEM images of the ceramic materials produced in Examples 3 and 5, respectively.

### Experimental Example 2. Crystal structure

The structure of the ceramic material produced in Example 2 was determined using a multi-purpose X-ray diffractometer. As shown in Fig. 7, the ceramic material LK99 was different in structure from apatite.

### Experimental Example 3. Raman measurement

The Raman spectra of the ceramic material produced in Example 2 were measured using a Raman spectrometer (NOST) and are shown in Fig. 8. Fig. 8 reveals the presence of phosphate groups in the inventive ceramic material.

### Experimental Example 4. Measurement of magnetic susceptibilities with varying temperatures

The magnetic susceptibilities of the ceramic material produced in Example 2 were measured using a SQUID-vibration sample magnetometer (Quantum Design MPMS3) and are shown in Figs. 13 to 15. Referring to these figures, the inventive ceramic material showed superconductivity.

### Experimental Example 5. Measurement of magnetic susceptibilities with varying magnetic fields

The magnetic susceptibilities of the ceramic material produced in Example 2 were measured using a SQUID-vibration sample magnetometer (Quantum Design MPMS3) and are shown in Figs. 16 to 18. Referring to these figures, the inventive ceramic material showed superconductivity.

### Experimental Example 6. Measurement of I-V changes

The I-V characteristics of the ceramic material produced in Example 1 were measured with varying temperatures by a 4-probe method using a KEITHLEY 228A power (voltage/current) source and a KEITHLEY 182 sensitive digital voltmeter. The results are shown in Fig. 33. Referring to Fig. 33, the I-V curve was steeply inclined with varying temperatures, that is, changes in voltage were observed in the +/- current directions, and the curve reached a plateau around 0 V where the current was constant, demonstrating the phenomenon of superconductivity in the ceramic material, as basically explained in Fig. 12.

Figs. 36 and 37 show changes in the I-V characteristics of the ceramic materials produced in Examples 3 and 5, respectively, demonstrating the phenomenon of superconductivity in the ceramic materials.

### Experimental Example 7. Measurement of I-V characteristics with varying temperatures

The I-V characteristics of the ceramic material produced in Example 2 were measured with varying temperatures by a 4-probe method using a KEITHLEY 228A power (voltage/current) source and a KEITHLEY 182 sensitive digital voltmeter. The results are shown in Figs. 19 to 21. These figures demonstrate superconductivity of the inventive ceramic material.

The resistivity of a commercial copper (Cu) foil is about 10⁻⁶ Ω·cm and is higher by about one order of magnitude than that of the inventive ceramic material.

Fig. 38 shows temperature-dependent superconductivity of the ceramic material.

### Experimental Example 8. Measurement of I-V characteristics with varying magnetic fields

The I-V characteristics of the ceramic material produced in Example 2 were measured with varying temperatures by a 4-probe method using a KEITHLEY 228A power (voltage/current) source and a KEITHLEY 182 sensitive digital voltmeter. The results are shown in Fig. 22. This figure demonstrates superconductivity of the inventive ceramic material.

Fig. 39 shows magnetic field-dependent superconductivity of the ceramic material.

### Experimental Example 9. Measurement of R-T characteristics with varying temperatures

The R-T characteristics of the ceramic material produced in Example 2 were measured with varying temperatures by a 4-probe method using a KEITHLEY 228A power (voltage/current) source and a KEITHLEY 182 sensitive digital voltmeter. The results are shown in Fig. 23. This figure demonstrates superconductivity of the inventive ceramic material.

Fig. 40 shows temperature-dependent R-T characteristics of the ceramic material produced by the solid-phase method in Example 4, where the Tc_III phase with the highest critical temperature was dominant. The critical temperature of the ceramic material was found to exceed -104 °C.

### Experimental Example 10. Analysis of composition of the ceramic material produced by solid-state reaction

The composition of the ceramic material produced in Example 4 was analyzed by FE-SEM/EDX. The results are shown in Figs. 24 to 27. Referring to the SEM images, the surface morphology of the ceramic material produced in Example 4 was similar to that of the ceramic material produced in Example 1. Referring to Fig. 28, the structure of the inventive ceramic material (LK99) was different from that of apatite.

Fig. 41 is a table showing the atomic ratios of the elements constituting the ceramic material produced in Example 4.

### Experimental Example 11. Measurement of electrical properties of the ceramic material produced by solid-state reaction

The ingot prepared by the solid-state reaction in Example 4 was processed into a rectangular shape and its resistances were measured with varying temperatures (304-382 K) by a 4-probe method using a KEITHLEY 228A power (voltage/current) source and a KEITHLEY 182 sensitive digital voltmeter. The results are shown in Fig. 29. Referring to Fig. 29, the inventive ceramic material showed superconductivity.

Fig. 42 is a photograph showing an experiment for measuring the resistance of the ceramic material in real time. The measured resistances were as low as approximately 10⁻¹²-10⁻¹⁰ Ohm·cm.

### Experimental Example 12. Crystal structure of the ceramic material produced by solid-state reaction

The crystal structure of the ceramic material produced in Example 4 was analyzed by XRD using a multi-purpose X-ray diffractometer (PHILIPS). The results are shown in Fig. 30. Referring to Fig. 30, the structure of the ceramic material (LK99) was different from that of apatite.

### Industrial applicability

The superconductivity of the ceramic material according to the present invention has been demonstrated with a partially filled SQW model. The ceramic material of the present invention will be a very useful material for the study of superconductivity puzzles at room temperature. All evidence and explanation lead to the conclusion that LK-99 is the first room-temperature and ambient-pressure superconductor. Therefore, it can be said that LK-99 is applicable to a wide variety of fields, including magnets, motors, cables, levitation trains, power cables, qubits for quantum computers, and THz antennas.

## Claims

1. A superconducting ceramic represented by Formula 1:
<Formula 1> **AₐB_{b}(EO₄)_{c}X_{d}**
wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4.

2. The superconducting ceramic according to claim 1, wherein raw materials for the ceramic material of Formula 1 are weighed such that the molar ratio **a:b:c:d** is in the range of 0-10:0-10:0-6:0-4.

3. The superconducting ceramic according to claim 1, wherein raw materials for the ceramic material of Formula 1 are weighed such that the molar ratio **a:b:c:d** is in the range of 0-10:0-10:0-6:0-4 and pretreated to synthesize a ceramic precursor.

4. The superconducting ceramic according to claim 1, wherein the ceramic material is colored white or black.

5. The superconducting ceramic according to claim 1, wherein the ceramic material is colored gray.

6. The superconducting ceramic according to claim 1, wherein the superconductivity of the ceramic material is determined by the temperature-dependent magnetic susceptibility of the ceramic material.

7. The superconducting ceramic according to claim 1, wherein the superconductivity of the ceramic material is determined by the magnetic field-dependent magnetic susceptibility of the ceramic material.

8. The superconducting ceramic according to claim 1, wherein the superconductivity of the ceramic material is determined by the temperature-dependent current-voltage characteristics of the ceramic material.

9. The superconducting ceramic according to claim 1, wherein the superconductivity of the ceramic material is determined by the magnetic field-dependent current-voltage characteristics of the ceramic material.

10. The superconducting ceramic according to claim 1, wherein the superconductivity of the ceramic material is determined by the temperature-dependent resistance-temperature characteristics of the ceramic material.

11. The superconducting ceramic according to claim 1, wherein, in Formula 1, **B** substitutes **A** or is introduced in empty spaces in the crystal structure of the ceramic material.

12. A method for producing a superconducting ceramic represented by Formula 1:
<Formula 1> **AₐB_{b}(EO₄)_{c}X_{d}**
wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4, the method comprising depositing raw materials under vacuum.

13. The method according to claim 12, wherein the raw materials for the ceramic material of Formula 1 are weighed such that the molar ratio **a:b:c:d** is in the range of 0-10:0-10:0-6:0-4.

14. The method according to claim 12, wherein the deposition is performed by heating to a reaction temperature of 550 to 2000 °C.

15. The method according to claim 12, wherein the raw materials for the ceramic material of Formula 1 are weighed such that the molar ratio **a:b:c:d** is in the range of 0-10:0-10:0-6:0-4 and pretreated to synthesize a ceramic precursor.

16. The method according to claim 15, wherein the pretreatment is performed at a reaction temperature of 550 to 1100 °C.

17. A method for producing a superconducting ceramic represented by Formula 1, the method comprising reacting lanarkite (L, Pb₂SO₅=PbO·PbSO₄) with copper phosphide (CusP).

18. The method according to claim 17, wherein the reaction is carried out at a temperature of 600 to 1000 °C.

19. The method according to claim 17, wherein the lanarkite is prepared by weighing PbO and PbSO₄ to have its composition, mixing the weighed raw materials, and heating the mixture.

20. The method according to claim 17, wherein the CusP is synthesized by weighing Cu and P to have its composition, mixing the weighed raw materials, and heating the mixture.

21. A superconducting ceramic produced by the method according to any one of claims 12 to 20, the superconducting ceramic being represented by Formula 1:
<Formula 1> **AₐB_{b}(EO₄)_{c}X_{d}**
wherein **A** is Ca, Ba, Sr, Sn or Pb as an s- or p-block metal, Y, La or Ce as an element of the lanthanide series or a combination thereof, **B** is Cu, Cd, Zn, Mn, Fe, Ni or Ag as a d-block metal or a combination thereof, **E** is P, As, V, Si, B, S or a combination thereof, **X** is F, Cl, OH, O, S, Se, Te or a combination thereof, **a** is 0 to 10, **b** is 0 to 10, **c** is 0 to 6, and **d** is 0 to 4.

22. The superconducting ceramic according to claim 21, wherein raw materials for the ceramic material of Formula 1 are weighed such that the molar ratio **a:b:c:d** is in the range of 0-10:0-10:0-6:0-4.

23. The superconducting ceramic according to claim 21, wherein raw materials for the ceramic material of Formula 1 are weighed such that the molar ratio **a:b:c:d** is in the range of 0-10:0-10:0-6:0-4 and pretreated to synthesize a ceramic precursor.

24. The superconducting ceramic according to claim 21, wherein the ceramic material is colored white or black.

25. The superconducting ceramic according to claim 21, wherein the ceramic material is colored gray.

26. The superconducting ceramic according to claim 21, wherein the superconductivity of the ceramic material is determined by the temperature-dependent magnetic susceptibility of the ceramic material.

27. The superconducting ceramic according to claim 21, wherein the superconductivity of the ceramic material is determined by the magnetic field-dependent magnetic susceptibility of the ceramic material.

28. The superconducting ceramic according to claim 21, wherein the superconductivity of the ceramic material is determined by the temperature-dependent current-voltage characteristics of the ceramic material.

29. The superconducting ceramic according to claim 21, wherein the superconductivity of the ceramic material is determined by the magnetic field-dependent current-voltage characteristics of the ceramic material.

30. The superconducting ceramic according to claim 21, wherein the superconductivity of the ceramic material is determined by the temperature-dependent resistance-temperature characteristics of the ceramic material.

31. The superconducting ceramic according to claim 21, wherein **B** substitutes **A** or is introduced in empty spaces in the crystal structure of the ceramic material.
